# EUROPEAN PATENT APPLICATION

(11) **EP 1 164 167 A1**
(43) Date of publication of application: **19.12.2001**
(21) Application number: 00970138.4
(22) Date of filing: 27.10.2000
(51) Int. Cl.: C08L 23/08, C08K 5/17, H01L 31/00

(54) **SEALING COMPOSITION AND SEALING METHOD**

(30) Priority: 01.11.1999 JP 31121699; 01.11.1999 JP 31121799
(71) Applicant: Bridgestone Corporation, Tokyo 104-8340 (JP)
(72) Inventor: KOMORI, Yushi Yokohama Plant Bridgestone Corp., Yokohama-shi, Kanagawa 244-0812 (JP); IINO, Yasuhiro Yokohama Plant Bridgestone Corp., Yokohama-shi, Kanagawa 244-0812 (JP)
(74) Representative: Jenkins, Peter David
(86) International application number: JP0007547
(87) International publication number: WO0132772

(57) **Abstract**

A sealing composition including ethylene-vinyl acetate copolymer (EVA), a cross-linking agent, and either a polymerization inhibitor or chain transfer agent. A method of sealing a device between two substrates through the following steps of; forming a layered structure by interposing the device sandwiched with two sheets or films made of the sealing composition in between two substrates to make a layered structure; deaerating the layered structure by heating under reduced pressure; unit the layered structure by curing (cross-linking) ethylene-vinyl acetate copolymer. By controlling an initial curing rate of the EVA sealing composition, sealing can be carried out with good productivity and high yield without problems of left bubbles and poor adhesion.

## Description

### Field of the invention

The present invention relates to a sealing composition, more particularly, to a sealing composition which is good for sealing electronic devices such as liquid crystal panels, solar cells, electro-luminescent devices, and plasma display units. The present invention also relates to a sealing method of electronic devices using the sealing composition.

### Background of the invention

A sealing composition firmly seals an electronic device, such as a liquid crystal panel, solar cell, electro-luminescent device, and plasma display unit in between two substrates made of glass, metal, plastic, rubber or other materials. The sealing composition protects the sealed electronic device from thermal expansion and shrinkage of substrates and from moisture. The sealing composition is made of silicone resin, epoxy resin, polyvinyl butyral resin, cellulose acetate, ethylene-vinyl acetate copolymer (EVA), or the like.

The sealing composition is to have the following features:
i) Securely protecting electronic devices from exposure to the outside environment, that is, moisture, the air, and so on, so as to prevent deterioration of these electronic devices.
ii) Cushioning properties for protecting electronic devices from mechanical shock.
iii) Strong adhesion both to electronic devices and substrates, easy handling, and simple sealing process.
iv) Good transparency, especially in use between transparent substrates made of glass, polymer film and the like.
v) Short curing time, good sealing efficiency, and securely protecting underlying electrical devices from shrinkage during curing.
vi) High electrical resistance and no conduction.
vii) Good weather resistance and durability in a long period of term.
viii) Low cost.
   Japanese Patent H6-35575B discloses a sealing composition including EVA, a silane coupling agent, and either organic peroxide or a photosensitizer as a cross-linking agent. This sealing composition has properties described in i)-viii), and, moreover, has properties ix) and x) in the following:
ix) Forming a sealing film with good transparence and high mechanical strength by cross-linking of EVA.
x) Forming a film or a sheet by a film forming method such as the calendar method, extrusion method, and blown-film extrusion method. The film or sheet has a good storage stability and its adhesion to a device lowers very little during storage at room temperature with normal humidity.

A sealing process at higher temperature allows having a shorter curing time and better productivity. However, when aforementioned conventional EVA sealing composition is processed at a high temperature, the curing rate determined by initial cross-linking reaction is so rapid that the curing process progresses further before the sealing composition is sufficiently deaerated and adhered to substrates and a device. As a result, bubbles are left in the cured composition and its adhesion to substrates and the device is not strong enough.

### Disclosure of the invention

An object of the present invention is to provide an EVA sealing composition which can seal devices with good productivity and high yield and overcomes problems of bubbles left in the cured composition and poor adhesion by controlling an curing rate at the initial stage of sealing process. It is another object to provide a sealing method using the sealing composition.

A sealing composition in the first embodiment of the present invention includes ethylene-vinyl acetate copolymer, a cross-linking agent, and a polymerization inhibitor.

By adding the polymerization inhibitor, polymerization reaction of free radicals is almost entirely inhibited. The polymerization inhibitor quickly reacts with free radicals generated from a polymerization initiator (a cross-linking agent in the present invention) or monomers to form stable free radicals which are hardly polymerized.

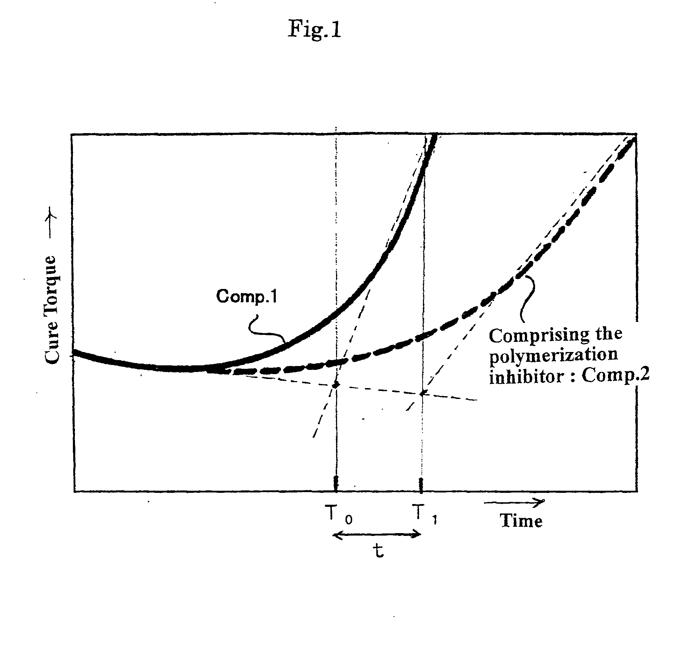

Therefore, polymerization (cross-linking) reaction does not occur until the polymerization inhibitor has been consumed. An example is shown in Fig. 1, where a solid line and a broken line indicate curing characteristics of a sealing composition without and with a polymerization inhibitor, respectively. Fig.1 shows that the curing starting time T₁ of the composition with the polymerization inhibitor is t hours later than the curing starting time T₀ of the composition without the polymerization inhibitor.

Therefore, cross-linking reaction of EVA on the initial stage is suppressed by adding a polymerization inhibitor and the curing starting time is delayed according to the amount of the polymerization inhibitor. Thus, the curing stating time is controlled to secure a time for sealing.

A sealing composition according to the second embodiment of the present invention includes ethylene-vinyl acetate copolymer, a cross-linking agent, and a chain transfer agent.

The chain transfer agent delays starting of polymerization reaction by chain transfer, that is, by transferring free radicals in polymerization (cross-linking) process. The chain transfer agent has no effect on the amount of polymerization in EVA through the cross-linking process.

The chain transfer agent interrupts cross-linking reaction of EVA at the early stage and delays the curing starting time according to the amount of the chain transfer agent. Thus, a curing starting time is controlled to secure a time for sealing. Whether the chain transfer agent is included or not, an amount of polymerization in EVA is the same, that is, hardness and adhesion strength of the cured EVA is not affected by the addition of the chain transfer agent.

As mentioned above, polymerization reaction (cross-linking reaction) of EVA composition including the polymerization inhibitor does not occur until the polymerization inhibitor has been consumed, so that its curing starting time can be delayed. However, the polymerization inhibitor has an effect on an amount of polymerization in EVA and decreases hardness and adhesion strength of the cured EVA.

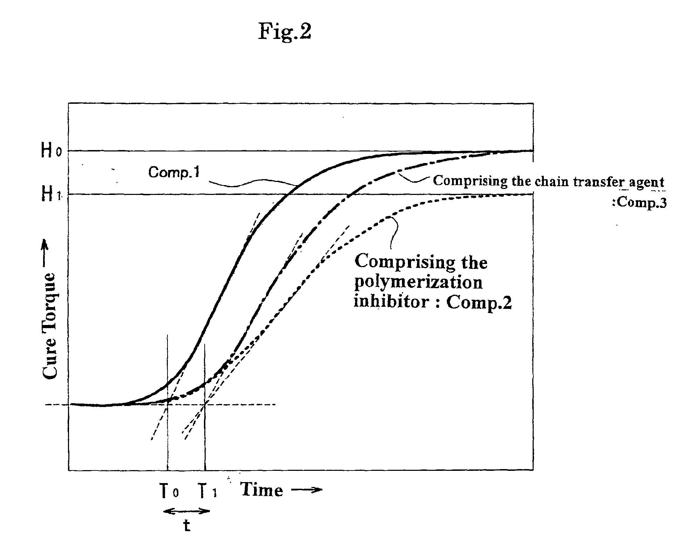

For example, an EVA composition, "Comp.1", including neither a chain transfer agent nor a polymerization inhibitor has the curing characteristics indicated by either the solid line in Fig. 1 or that in Fig.2. An EVA composition, "Comp.2", prepared by adding a polymerization inhibitor into Comp.1 has the curing characteristics indicated by either the broken line in Fig. 1 or that in Fig.2. The curing starting time T₁ of Comp.2 is t hours later than the curing starting time T₀ of Comp.1.

An EVA composition, Comp.3, prepared by adding a chain transfer agent into Comp.1, has the curing characteristics indicated by the dot-dash line in Fig.2. The amount of the chain transfer agent in Comp.3 is determined so as to make the curing starting time of Comp.3 later than that of Comp. 1 by t hours.

As shown in Fig.2, Comp.1 including neither a polymerization inhibitor nor a chain transfer agent and Comp.3 including only chain transfer agent have the same hardness H₀ after cured. As aforementioned, an amount of polymerization in EVA with the chain transfer agent is exactly the same as that in EVA without the chain transfer agent.

On the other hand, after cured, Comp.2 prepared by adding the polymerization inhibitor into Comp.1 has a lower hardness H₁ than H₀.

According to the sealing method of the present invention, a device is sealed in between two substrates through the following steps; interposing each of two sheets or films made of the sealing composition of the present invention in between a device and each of two substrates to make a layered structure; deaerating the layered structure by heating under a reduced pressure; curing ethylene-vinyl acetate copolymer by cross-linking to unite the layered structure. By this sealing method, a sufficient time is ensured before the curing starts even at a high temperature.

### Brief description of the drawings

Fig. 1 shows curing characteristics of the sealing compositions.
Fig.2 shows curing characteristics of the sealing compositions.

### Preferred embodiments of the present invention

In the present invention, the amount of vinyl acetate in EVA is preferably 5 to 50wt. %, more preferably 15 to 40wt. %. When the amount of vinyl acetate is smaller than 5 wt.%, weather resistance and transparence of EVA becomes poor. When the amount of vinyl acetate exceeds 50wt.%, mechanical properties of EVA lower considerably, it becomes troublesome to make EVA film, and, furthermore, blocking of EVA sheets or films occurs. The amount of vinyl acetate can be less than 5wt.% when transparence of the sealing composition does not matter, for example, when the composition is used on the backside of a product

A polymerization inhibitor inhibits cross-linking reaction of EVA. The polymerization inhibitor may be a stable radical substance such as diphenylpicryl hydrazyl, garbinoxyl, and ferdazyl. The polymerization inhibitor may also be a substance easily forming stable radicals by adding to radicals, for example, enzymes, phenol derivatives, benzoquinone derivatives, and nitro-compounds. An amount of the polymerization inhibitor is determined suitably according to the amount of the cross-linking agent in the sealing composition, processing temperature, desired curing starting time, and so on. When one or more than two substances are selected from the group consisting of N-nitrosophenyl hydroxylamine ammonium salt, hydroquinone, and the like as polymerization inhibitors, the total amount of the polymerization inhibitor is preferably in a range of 0.01 to 5 parts by weight for 100 parts by weight of EVA.

A chain transfer agent delays cross-linking reaction of EVA. The chain transfer agent may be a compound such as chloroform, carbon tetrachloride, mercaptan compounds, and styrene dimer. The chain transfer agent is preferably added in an amount of 0.01 to 5 parts by weight for100 parts by weight of EVA, though not limitative thereto. An amount of the chain transfer agent is suitably determined according to the amount of the cross-linking agent in the sealing composition, processing temperature, desired curing starting time, and so on.

When EVA is cross-linked by heat, organic peroxide is suitable for a cross-linking agent. Examples of such cross-linking agents include 2,5-dimethyl hexane-2,5-dihydroperoxide; 2,5-dimethyl-2,5-di(t-butylperoxy)hexane-3; di-t-butyl peroxide; t-butylcumyl peroxide; 2,5-dimethyl-2,5-di(t-butylperoxy)hexane; dicumyl peroxide; α, α'-bis(t-butylperoxyisopropyl)benzene; n-butyl-4,4-bis(t-butylperoxy)valerate; 2,2-bis(t-butylperoxy)butane; 1,1-bis(t-butylperoxy)cyclohexane; 1,1-bis(t-butylperoxy)-3,3,5-trimethylcyclohexane; t-butylperoxy benzoate; benzoyl peroxide; t-butylperoxy acetate; 2,5-dimethyl-2,5-bis(t-butylperoxy)hexyne-3; 1,1-bis(t-butylperoxy)-3,3,5-trimethylcyclohexane; 1,1-bis(t-butylperoxy)cyclohexane; methyl ethyl ketone peroxide; 2,5-dimethylhexyl-2,5-bisperoxy benzoate; t-butyl hydroperoxide; p-menthane hydroperoxide; p-chlorobenzoyl peroxide; t-butyl peroxyisobutyrate; hydroxyheptyl peroxide; chlorohexanone peroxide. A cross-linking agent is selected from them taking account of processing temperature of films, cross-linking temperature, required storage stability, and so on.

One or more than two cross-linking agents are selected from organic peroxides and added into EVA preferably in an amount of not greater than 5 parts by weight, more preferably 0.5 to 2 parts by weight, for 100 parts by weight of EVA.

Organic peroxide may be kneaded with EVA by an extruder, a roller mill, or the like. Or, organic peroxide may be added to EVA by the impregnation method in which sheets or films made of EVA are impregnated with the organic peroxide dissolved into an organic solvent, a plasticizer, vinyl monomers, or the like.

In order to improve properties of EVA (for example, mechanical strength, optical properties, adhesion, weather resistance, milkiness resistance, cross-linking rate and so on), compounds including an acryloxy group, a methacryloxy group, or an allyl group may be added. For this purpose, derivatives of acrylic acid or methacrylic acid, for example, esters or amides of acrylic acid or methacrylic acid are most commonly used. A hydrocarbon group of ester can be an alkyl group (methyl, ethyl, dodecyl, stearyl, lauryl, and the like), cyclohexyl group, tetrahydrofurfuryl group, aminoethyl group, 2-hydroxyethyl group, 3-hydroxypropyl group, 3-chloro-2-hydroxypropyl group, and the like. Ester of multifunctional alcohol, such as ethylene glycol, triethylene glycol, polyethylene glycol, trimetylolpropane, and pentaerythritol can also be used. Among amides, diacetone acrylamide is suitable.

More specifically, one or more than two substances selected from the group consisting of multifunctional esters (esters of acrylic acid or methacrylic acid with trimethylolpropane, pentaerythritol, or glycerin, and the like) and compounds including allyl groups (triallyl cyanurate, triallyl isocyanurate, diallyl phthalate, diallyl isophthalate, diallyl maleate, and the like) are preferably added in an amount of 0.1 to 10 parts by weight, more preferably 0.5 to 5 parts by weight, for 100 parts by weight of EVA. When the amount is less than 0.1 parts by weight, the effect is very little, and when the amount exceeds 10 parts by weight, quality of EVA lowers, that is, EVA becomes brittle.

When EVA is cross-linked by light, a photosensitizer, instead of aforementioned organic peroxide, is preferably added in an amount of not greater than 5 parts by weight, more preferably 0.5 to 2 parts by weight, for 100 parts by weight of EVA.

One or more than two substances are selected as the photosentisizer(s) from the group consisting of benzoin, benzophenone, benzoin methyl ether, benzoin ethyl ether, benzoin isopropyl ether, benzoin isobutyl ether, dibenzyl, 5-nitroacenaphthene, hexachlorocyclopentadiene, p-nitrodiphenyl, p-nitroaniline, 2,4,6-trinitroaniline, 1,2-benzanthraquinone, 3-methyl-1,3-diaza-1,9-benzanthrone, and the like.

In the present invention, a silane coupling agent may be added to EVA as an adhesion accelerator. One or more than two compounds are selected as the silane coupling agent(s) from the group consisting of vinyltriethoxysilane, vinyl-tris(β-methoxyethoxy)silane, γ-methacryloxypropyltrimethoxysilane, vinyltriacetoxysilane, γ -glycidoxypropyltrimetoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropyltrimethoxysilane, γ-aminopropyltriethoxysilane, N- β (aminoethyl)- γ-aminopropyltrimethoxysilane, and the like. The amount of the silane coupling agent is preferably in a range of 0.01 to 10 parts by weight, more preferably 0.01 to 5 parts by weight, for 100 parts by weight of EVA.

In addition to the aforementioned additives, the sealing composition of the present invention may include small amounts of an ultraviolet light absorber, infrared light absorber, anti-aging agent and coating aid. The sealing composition may also include a colorant such as dye and pigment in order to adjust color shade of the sealing film itself and a filler such as carbon black, hydrophobic silica, and calcium carbonate in suitable amounts.

Sheets or films made of the sealing composition may be treated by the corona discharge treatment, low-temperature plasma treatment, electron irradiation, ultraviolet-light irradiation, or the like in order to improve the adhesion.

Sealing sheets or films made of the sealing composition of this invention are prepared through the following steps: EVA and the aforementioned additives are mixed and kneaded by an extruder, a roller or the like; the kneaded composition is formed into sheets or films in specified shapes by the calendar method, roll method, T-die extrusion method, inflation method, or other method. In the forming process, the sheets or films may be embossed to prevent blocking and to make deaeration easy when the sheets or films are pressed together with substrates and a device to be sealed.

A thickness of the sheet or film is preferably in a range between 100 µm and 300 µm, though not limitative thereto. The thickness is suitably determined according to a device to be sealed, the use of the product, and so on.

The sheets or films seal a device in between a pair of substrates. The device may be an electronic device, for example, a liquid crystal panel, solar cell, electro-luminescent device, and plasma display unit. The substrates may be sheets or films made of glass, metal, plastic, rubber, or other materials. Each of two sealing sheets or films is interposed between the device and each of two substrates to make a layered structure. The layered structure is deaerated by heating under reduced pressure. Then, the layered structure is united together through curing (cross-linking) by heat or light under the condition suitable to the included cross-linking agent.

Hereinafter, the present invention will be illustrated with Examples. In the following, "parts" means "parts by weight".

### Example 1

100 parts of EVA (Ultrasen 634 manufactured by Toyo Soda Co., Ltd.; vinyl acetate content is 26 wt.%, melt index 4), 1 part of dicumyl peroxide, 0.5 parts of γ-methacryloxypropyltrimethoxysilane, and 0.02 parts of N-nitrophenylhydroxyl ammonium salt as a polymerization inhibitor were mixed and extruded by an extruder to form a double-side embossed sheet (900mm width) having a thickness of 0.4mm. The curing starting time (T1 in Fig.1) of the embossed sheet was measured by heating the embossed sheet at 120°C. The curing stating time was 10 minutes after starting heating.

White sheet glass and stainless steel sheet (SUS 430) were washed and dried. A solar cell module was sandwiched with two embossed sheets and, further, they are sandwiched with the white sheet glass and the stainless steel sheet to make a layered structure. The layered structure was deaerated at 100 °C by a vacuum laminator.

Then, cross-linking of the embossed sheets was carried out at 150 °C for 30 minutes. The obtained module was transparent and strongly adhered both to the white sheet glass and the stainless steel sheet.

From the observation of the appearance of the obtained module no bubbles were found, and the module had high quality and excellent adhesion strength.

### Example 2

100 parts of EVA (Ultrasen 634 manufactured by Toyo Soda Co., Ltd.; vinyl acetate content is 26 wt.%, melt index 4), 1 part of dicumyl peroxide, 0.5 parts of γ-methacryloxypropyltrimethoxysilane, and 0.02 parts of carbon tetrachloride as a chain transfer agent were mixed and extruded by an extruder to form double-side embossed sheet (900mm width) having a thickness of 0.4mm. The curing starting time (T1 in Fig.2) of the embossed sheet was measured by heating the embossed sheet at 120°C. The curing starting time was 10 minutes after starting heating.

White sheet glass and stainless steel sheet (SUS 430) were washed and dried. A solar cell module was sandwiched with two embossed sheets and, further, they are sandwiched with the white sheet glass and the stainless steel sheet to make a layered structure. The layered structure was deaerated at 100 °C by a vacuum laminator.

Then, cross-linking of the embossed sheets was carried out at 150 °C for 30 minutes. The obtained module was transparent and strongly adhered both to the white sheet glass and the stainless steel sheet.

From the observation of the appearance of the obtained module no bubbles were found, and the module had high quality and excellent adhesion strength.

### Industrial Application

As described above, according to the present invention, a sealing composition of EVA having various excellent sealing properties can be provided. The composition includes a polymerization inhibitor or a chain transfer agent in order to control curing tune (cross-linking time) of EVA and to secure a time for sealing process. After sealing, the cured composition does not include any bubbles.

A sealing composition and a sealing method of the present invention are very useful to seal an electronic device such as a liquid crystal panel, solar cell, electro-luminescent device, and plasma display unit in between substrates made of glass, metal, plastic, rubber, or other materials.

## Claims

1. A sealing composition including ethylene-vinyl acetate copolymer, a cross-linking agent and a polymerization inhibitor.

2. A sealing composition as claimed in claim 1, wherein the polymerization inhibitor is N-nitrosophenylhydroxylamine ammonium salt and/or hydroquinone.

3. A sealing composition as claimed in claims 1 or 2, wherein the amount of the polymerization inhibitor is 0.01-5 parts by weight for 100 parts by weight of ethylene-vinyl acetate copolymer.

4. A sealing composition including ethylene-vinyl acetate copolymer, a cross-linking agent, and a chain transfer agent.

5. A sealing composition as claimed in claim 4, wherein the chain transfer agent is at least one selected from the group consisting of chloroform, carbon tetrachloride, mercaptane compounds and styrene dimer.

6. A sealing composition as claimed in claims 4 or 5, wherein the amount of the chain transfer agent is 0.01-5 parts by weight for 100 parts by weight of ethylene-vinyl acetate copolymer.

7. A sealing composition as claimed in any one of claims 1 through 6, wherein the cross-linking agent is organic peroxide or a photosensitizer.

8. A sealing composition as claimed in claim 7, wherein the amount of the cross-linking agent is not greater than 5 parts by weight for 100 parts by weight of ethylene-vinyl acetate copolymer.

9. A sealing composition as claimed in any one of claims 1 through 8, also including a silane coupling agent.

10. A sealing composition as claimed in claim 9, wherein the amount of the silane coupling agent is 0.01-10 parts by weight for 100 parts by weight of ethylene-vinyl acetate copolymer.

11. A sealing composition as claimed in any one of claims 1 through 10, also including either (meth)acrylic acid ester or a compound including an allyl group.

12. A sealing composition as claimed in claim 11, wherein the amount of the compound is 0.1-10 parts by weight for 100 parts by weight of ethylene-vinyl acetate copolymer.

13. A sealing composition as claimed in any one of claims 1 through 12, wherein the amount of vinyl acetate in ethylene-vinyl acetate copolymer is 5-50 wt.%.

14. A sealing composition as claimed in any one of claims 1 through 13, used for sealing electronic devices.

15. A method of sealing a device between two substrates, including the following steps of:
forming a layered structure by interposing each of two sheets or films made of the sealing composition described in any one of claims 1 through 14 in between the device and each of two substrates;
deaerating the layered structure by heating under reduced pressure; and
uniting the layered structure by curing (cross-linking) ethylene-vinyl acetate copolymer.
